(19) Europäisches Patentamt / European Patent Office / Office européen des brevets

(11) **EP 2 921 887 B1**

(12) **EUROPEAN PATENT SPECIFICATION**

(45) Date of publication and mention
of the grant of the patent:
**04.07.2018 Bulletin 2018/27**

(21) Application number: **13855352.4**

(22) Date of filing: **14.11.2013**

(51) Int Cl.:
*G01W 1/16* [(2006.01)]     *G01R 33/02* [(2006.01)]

(86) International application number:
**PCT/JP2013/080836**

(87) International publication number:
**WO 2014/077337 (22.05.2014 Gazette 2014/21)**

(54) **LIGHTNING-STRIKE ELECTRIC CHARGE ESTIMATION SYSTEM AND METHOD**

SYSTEM UND VERFAHREN ZUR SCHÄTZUNG DER ELEKTRISCHEN LADUNG VON BLITZSCHLÄGEN

SYSTÈME D'ESTIMATION DE CHARGE ÉLECTRIQUE DE FOUDROIEMENT ET PROCÉDÉ ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.11.2012 JP 2012251493**

(43) Date of publication of application:
**23.09.2015 Bulletin 2015/39**

(73) Proprietors:
• **Tohoku Electric Power Co., Inc.**
**Sendai-shi, Miyagi 980-8550 (JP)**
• **National University Corporation
Hokkaido University**
**Sapporo-shi, Hokkaido 060-0808 (JP)**
• **Tohoku University**
**Sendai-shi, Miyagi 980-8577 (JP)**

(72) Inventors:
• **HONMA Noriyasu**
**Sendai-shi, Miyagi 981-0952 (JP)**
• **HONGO Yasuji**
**Sendai-shi, Miyagi 981-0952 (JP)**
• **TAKAHASHI Yukihiro**
**Sapporo-shi, Hokkaido 060-0808 (JP)**
• **SATO Mitsuteru**
**Sapporo-shi, Hokkaido 060-0808 (JP)**
• **TSUCHIYA Fuminori**
**Sendai-shi, Miyagi 980-8577 (JP)**
• **TSURUSHIMA Daiki**
**Sendai-shi, Miyagi 980-8577 (JP)**

(74) Representative: **V.O.**
**P.O. Box 87930**
**2508 DH Den Haag (NL)**

(56) References cited:
JP-A- H07 151 866     JP-A- 2006 275 845
US-A1- 2008 122 424    US-B2- 6 791 311

• STEVEN A. CUMMER ET AL: "Unusually intense continuing current in lightning produces delayed mesospheric breakdown", GEOPHYSICAL RESEARCH LETTERS, vol. 28, no. 3, 1 February 2001 (2001-02-01), pages 495-498, XP055270155, United States ISSN: 0094-8276, DOI: 10.1029/2000GL012214
• CUMMER S A ET AL: "Modeling ELF radio atmospheric propagation and extracting lightning currents from ELF observations", RADIO SCIENCE, AMERICAN GEOPHYSICAL UNION, WASHINGTON, DC, US, vol. 35, no. 2, 1 March 2000 (2000-03-01), pages 385-394, XP008111430, ISSN: 0048-6604
• CUMMER A.: 'UNUSUALLY INTENSE CONTINUING CURRENT IN LIGHTNING PRODUCES DELAYED MESOSPHERIC BBREAKDOWN' GEOPHYSICAL RESEARCH LETTERS vol. 28, no. 3, 01 February 2001, pages 495 - 498, XP055254486

EP 2 921 887 B1

• HIRONAO KAWAMURA: 'OBSERVATION OF WINTER LIGHTNING AND ITS CHARACHTERISTICS IN THE HOKURIKU AREA WITH UTILIZING ELECTROMAGNETIC WAVE 1 SEARCHING FOR NATURE SECRETS IN THE HOKURIKU DISTINCT ELECTRONICS WAVES AS A TOOL FOR DISCOVERY' JOURNAL OF THE INSTITUTE OF ELECTRONICS INFORMATION AND COMMUNICATION vol. 93, no. 10, 01 October 2010, pages 828 - 830, XP008179239

## Description

Technical Field

The present disclosure relates to a system and a method for estimating an electric charge, by which the electric charge of a lightning strike is estimated.

Background Art

Lightning strikes cause various kinds of damage, such as breakage and erosion, to buildings, electric and communication facilities, and the like. Therefore, research and development of technologies for estimating the locations and electric charges of lightning strikes have been extensively performed.

Patent Literature 1 discloses a lightning location system, in which characteristic electric waves generated by a lightning strike are measured at a plurality of points, to estimate the location of the lightning strike based on a difference between receipt times and the arrival bearings of the electric waves.

The lightning location system estimates the peak value of a lightning current based on a relationship in which the peak value of a high feedback current passing just after an electric discharge drops from a thundercloud and arrives at the earth is in proportion to the peak value of electric wave intensity and to a distance from a lightning strike.

However, for evaluating the influence of the lightning strike, only the estimation of the peak value of the lightning current is insufficient, and it is necessary to determine the total of electric charges passing due to the lightning current. However, the lightning location system is incapable of determining the total of the electric charges. In addition, the lightning location system is incapable of estimating the current of a lightning strike in a type in which an electric discharge rises from the earth toward a thundercloud.

As technologies for estimating the electric charge of a lightning strike, there have been known: a technology in which an electric charge is estimated from a voltage generated in a shunt resistance by a current passing into the shunt resistance inserted between a structure receiving lightning and the earth; and a technology in which a magnetic field made by a current passing through a structure receiving lightning is measured by a Rogowski coil to estimate an electric charge from the measured magnetic field. In the technologies, the electric charge can be estimated only in a case in which an observation facility is struck by lightning and measurement data is obtained. In addition, obtained measurement information is limited to the data of a specific kind of a lightning strike such as a lightning strike to a high structure struck by lightning with a high frequency. In actuality, it is difficult to predict when a lightning strike is generated and to predict a point at which the lightning strike is generated. Therefore, such conventional technologies for estimating electric charges by lightning strikes are incapable of determining the electric charges of lightning strikes to various structures in a wide region.

Citation List

Patent Literature

Patent Literature 1: Unexamined Japanese Patent Application Kokai Publication No. 2006-194643.

Non Patent Literature 1: "Unusually intense continuing current in lightning produces delayed mesospheric breakdown", GEOPHYSICAL RESEARCH LETTERS, vol. 28, no. 3, 1 February 2001 (2001-02-01), pages 495 - 498, XP055270155 by Steven A. Cummer et al. discloses that ultra low frequency magnetic field measurements made 500-2000 km from positive lightning discharges show a signature that is consistent with unusually high amplitude cloud-to-ground continuing lightning current. The magnitude of this nearly constant current moment is as large as 60 kA km and can last at half this amplitude for longer than 150 ms, thereby moving 640 C or more (assuming a 7 km vertical channel length) to the ground after the return stroke.

Non Patent Literature 2: "Modeling ELF radio atmospheric propagation and extracting lightning currents from ELF observations", RADIO SCIENCE, AMERICAN GEOPHYSICAL UNION, WASHINGTON, DC, US, vol. 35, no. 2, 1 March 2000 (2000-03-01), pages 385 - 394, XP008111430 by Steven A. Cummer et al. discloses modelling broadband extremely low frequency (ELF) radio atmospherics (sferics) waveforms by adapting a single-frequency ELF propagation code to calculate an ELF propagation impulse response under the assumption of horizontal ionospheric homogeneity, with which the source lightning current waveform is extracted from an observed ELF sferic waveform using a deconvolution method based on linear regularization.

Summary of Invention

Technical Problem

The present disclosure is achieved with respect to the circumstances described above. An objective of the present disclosure is to provide a system and a method for estimating the electric charge of a lightning strike, by which the electric charges of lightning strikes to various objects in a wide region can be easily estimated.

Solution to Problem

A system for estimating the electric charge of a lightning strike according to the present invention is defined in claim 1.

The system for estimating the electric charge of a lightning strike according to the present disclosure utilizes a property, in which a magnetic field obtained by measuring a magnetic field generated by a lightning strike in a low-frequency band of 200 Hz or less is similar to a current caused by the lightning strike, to thereby determine the current based on the magnetic field. In addition, the system for estimating the electric charge of a lightning strike integrates the current to thereby determine an electric charge passed through the earth by the lightning strike to estimate the electric charge of the lightning strike. The combination of the estimated electric charge of the lightning strike and the information of a lightning location determined by a lightning location system (LLS) or the like enables potential damage caused by a lightning strike, such as the erosion of a power transmission line, to be estimated and a material for judging the need of measures against damage to be provided.

In the system for estimating the electric charge of a lightning strike according to the present disclosure, measurement of a magnetic field in a low-frequency band including a frequency of 200 Hz or less enables remote observation of even a lightning strike generated at a place apart by up to several hundred kilometers. Therefore, a wide area can be covered by one observation device, and observation efficiency is high. In addition, the number of observation devices can be decreased, and the installation cost of a new observation device can be reduced.

In the system for estimating the electric charge of a lightning strike according to the present disclosure, the frequency band preferably includes a frequency of 100 Hz or less in a wide band. In this case, a measured magnetic field waveform and a current waveform coincide well with each other, and the precision of the estimation of the electric charge can be enhanced.

The system for estimating the electric charge of a lightning strike according to the present disclosure may further include filter means for filtering the magnetic field, measured by the magnetic field measurement means, at a cut-off frequency of 100 Hz on a high frequency side. In this case, the electric charge calculation means may determine an electric charge based on the magnetic field filtered by the filter means. In this case, the filtered magnetic field and a current coincide further well with each other, and the precision of the estimation of the electric charge can be enhanced.

In the system for estimating the electric charge of a lightning strike according to the present disclosure, the magnetic field measurement means may be capable of measuring the two quadrature components of a magnetic field generated by a lightning strike. In this case, the system for estimating the electric charge of a lightning strike may include bearing estimation means that determine the bearing of the location of the lightning based on each component of the magnetic field measured by the magnetic field measurement means. In this case, the precision of the measurement of the lightning location can be enhanced by combination with a lightning location system or the like.

In the system for estimating the electric charge of a lightning strike according to the present disclosure, the magnetic field measurement means may include a low-frequency region in the frequency band of a measurement target so that the measured magnetic field excludes the value of a polarity opposite to an initial polarity. Alternatively, the electric charge calculation means may make a correction so that a magnetic field or a current determined based on the magnetic field excludes the value of a polarity opposite to an initial polarity, followed by determining the electric charge. In this case, the precision of the estimation of the electric charge can be enhanced.

The electric charge calculation means includes, for example: means for determining the current of a lightning strike by multiplying the measured magnetic field by a pre-set magnetic field-current conversion coefficient; means for multiplying the determined current by a correction coefficient based on the length and inclination of a discharge path; and integration means that integrates the current multiplied by the correction coefficient.

The magnetic field-current conversion coefficient is set, for example, in consideration of at least one of the attenuation of a magnetic field, depending on a distance between a lightning point and a magnetic field measurement point, and the attenuation of a magnetic field, depending on the state of the ionosphere.

In addition, a method for estimating the electric charge of a lightning strike according to the present invention is defined in claim 10.

A program of the present invention is defined in claim 11.

Advantageous Effects of Invention

According to the present disclosure, the electric charge of a lightning strike generated over a wide region can be estimated using an observation facility installed far away from a lightning point.

Brief Description of Drawings

FIG. 1 is a block diagram of a system for estimating the electric charge of a lightning strike according to an embodiment of the present disclosure;
FIG. 2 is a view illustrating a specific configuration example of an electric charge calculator illustrated in FIG. 1;
FIG. 3 is a view illustrating a configuration example of data stored in a storage device illustrated in FIG. 1;
FIG. 4 is a view for explaining a technique for determining a lightning point to determine a distance to the lightning point;
FIG. 5 is a view illustrating a configuration example of data stored in a magnetic field-current ratio table illustrated in FIG. 1;
FIG. 6 is a flowchart of operation of the system for estimating the electric charge of a lightning strike with the configuration illustrated in FIG. 1 to FIG. 5;
FIG. 7 is a graph illustrating the former portion of a current waveform observed in a Rogowski coil in Mt. Ogami, with regard to a lightning strike generated in Mt. Ogami, in relation to the system for estimating the electric charge of a lightning strike according to an embodiment of the present disclosure;
FIG. 8 is a graph illustrating the waveform of a magnetic-field component observed with search coil magnetic field meters in the Onagawa observatory, with regard to the same lightning strike generated in Mt. Ogami, in relation to the system for estimating the electric charge of a lightning strike of an embodiment of the present disclosure;
FIG. 9 is a graph illustrating a current waveform obtained by filtering (attenuation factor: -6 dB/octave) the current waveform illustrated in FIG. 7 at a cut-off frequency of 90 Hz in a high frequency side;
FIG. 10 is a schematic diagram of a cylindrical coordinate system FDTD simulation for reproducing the propagation of an electromagnetic pulse under the ionosphere at 296 km from lightning generated in Mt. Ogami to the Onagawa observatory, in relation to the system for estimating the electric charge of a lightning strike of an embodiment of the present disclosure;
FIG. 11 is a graph illustrating a horizontal magnetic field waveform in a distance of 298 km from the lightning, obtained by the simulation illustrated in FIG. 10;
FIG. 12 is a graph illustrating horizontal magnetic field waveforms at a propagation distance of 298 km, obtained by the simulation illustrated in FIG. 10, assuming that a lightning current is a Gaussian pulse with a peak half height width of 4 ms;
FIG. 13 is a graph illustrating relationships between the logarithmic peak values of horizontal magnetic field pulses and logarithmic propagation distances, obtained by the simulation illustrated in FIG. 4, on the same conditions as those of FIG. 12; and
FIG. 14 is a graph illustrating the propagation distance dependency of the bipolarity ratios of magnetic field pulses, obtained by the simulation illustrated in FIG. 13, with varying the peak half height width of a current pulse.

Description of Embodiments

A system for estimating the electric charge of a lightning strike according to an embodiment of the present disclosure will be explained below.

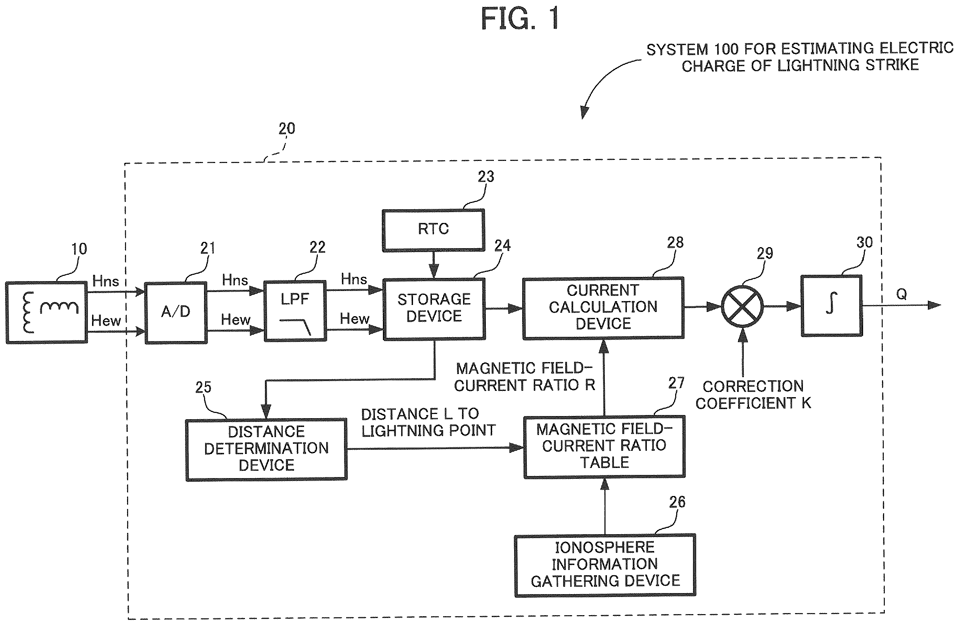

As illustrated in FIG. 1, the system 100 for estimating the electric charge of a lightning strike according to the present embodiment comprises a magnetic field measurer 10 and an electric charge calculator 20.

The magnetic field measurer 10 comprises search coil magnetic field meters with directivities in the north-south direction and the east-west direction, respectively. The magnetic field measurer 10 measures the two horizontal components Hns and Hew of a magnetic field generated by a lightning strike in the geographical north-south (latitudinal) and east-west directions in a low-frequency band of 200 Hz or less. The measurement range of the magnetic field measurer 10 desirably includes a low frequency region in such a manner that the measurement range is 0.1 Hz or more so that the measured magnetic field excludes a negative-polarity component. In addition, the measurement range may also be 100 Hz or less. However, it is desirable that there is sufficient sensitivity in the vicinity of 100 Hz.

The magnetic field measurer 10 supplies the magnetic-field component Hns in the north-south direction and the magnetic-field component Hew in the east-west direction, which have been measured, to the electric charge calculator 20.

The electric charge calculator 20 comprises computer devices and functionally comprises an A/D converter 21, a low-pass filter (LPF) 22, an RTC 23, a storage device 24, a distance determination device 25, an ionosphere information gathering device 26, a magnetic field-current ratio table 27, a current calculation device 28, a multiplication device 29, and an integration device 30.

The A/D converter 21 converts a magnetic-field component Hns in the north-south direction and a magnetic-field component Hew in the east-west direction, measured by the magnetic field measurer 10, into digital data. The sampling period $\Delta t$ of the A/D converter 21 is, for example, 5 ms to 10 $\mu$s, desirably around 100 $\mu$s.

The low-pass filter 22 comprises a digital filter and extracts and outputs a low-frequency component at a cut-off frequency of about 100 Hz. As a result, similarity between the waveform of an actually measured magnetic field and the waveform of an actual magnetic field is enhanced.

The RTC (Real Time Clock) 23 measures a current date, hour, minute, and second. The configuration in itself of the RTC 23 is optional and, for example, may comprise a self-run timer or may comprise a GPS (Global Positioning System) timer.

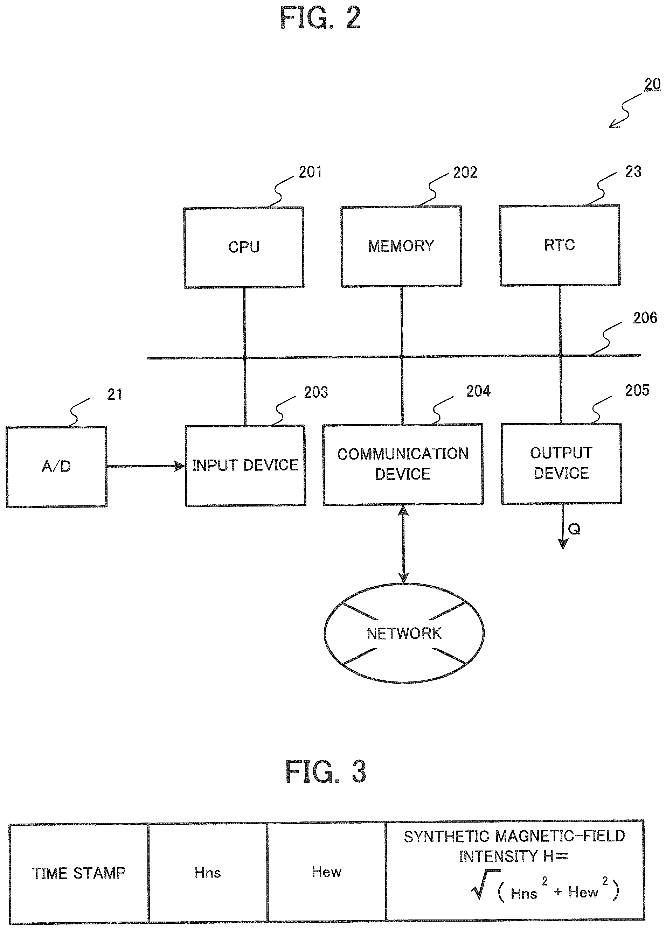

The storage device 24 accumulates the magnetic-field components Hns and Hew passing through the low-pass filter 22 in association with the current time measured by the RTC 23, as illustrated in FIG. 3. The storage device 24 also determines and stores the synthetic intensity H = $\sqrt{(Hns^2 + Hew^2)}$ of the measured magnetic field.

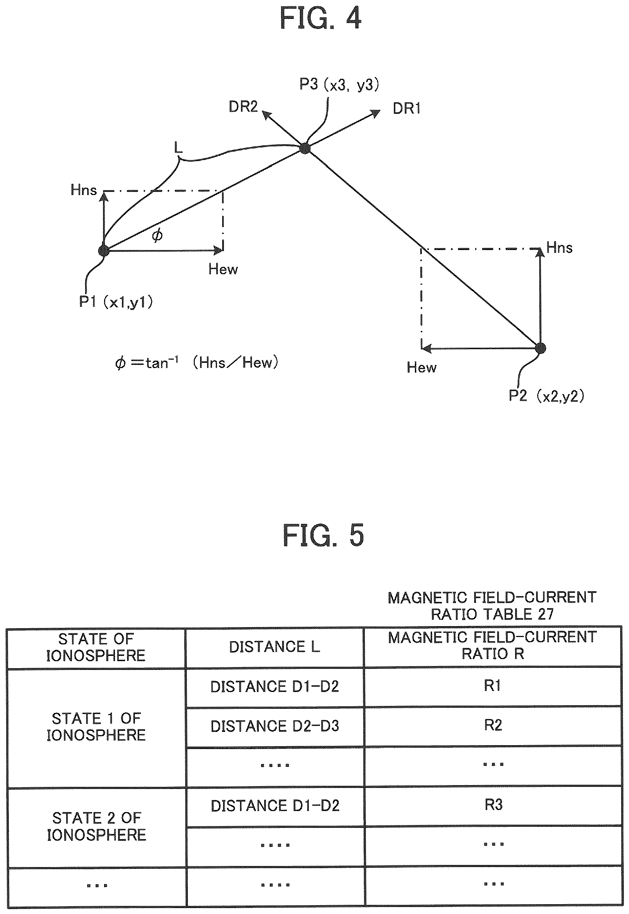

The distance determination device 25 specifies a lightning point based on the magnetic-field components Hns and Hew passing through the low-pass filter 22 and on information from a lightning location system installed at another point, and the like, and determines a distance from the installation point of the magnetic field measurer 10. More specifically, the distance determination device 25 i) determines the direction DR1 (inclination angle $\varphi$ = tan$^{-1}$ (Hns/Hew) based on the east-west direction) of the generation of the lightning strike based on the magnetic-field components Hns and Hew passing through the low-pass filter 22, ii) overlaps the determined direction DR1 with a lightning strike generation direction DR2 determined by a lightning direction estimation system installed at another point P2, to thereby specify a lightning point P3 by a triangulation technique, and iii) determines a distance L (= $\sqrt{(x1 - x3)^2 + (y1 - y3)^2}$) between the installation point P1 of the magnetic field measurer 10 and the lightning point P3, as illustrated in FIG. 4.

The ionosphere information gathering device 26 gathers ionosphere information representing the state of the ionosphere via a network. The ionosphere information may include information such as discrimination between day and night.

The magnetic field-current ratio table 27 associates and stores a distance L between a magnetic field observation point and a lightning point and information representing a correlation between the synthetic intensity H = $\sqrt{(Hns^2 + Hew^2)}$ of an observed magnetic field and a current passed by a lightning strike, according to the state of the ionosphere, as illustrated in FIG. 5. The items of the information are determined, by statistical processing of actually measured values and experimental values, a simulation, or the like. In addition, since the intensity of a magnetic field is influenced by the length of a discharge path for a lightning strike, a magnetic field-current intensity ratio is a value assuming that the discharge path has a length DL (optional constant) and is vertical to the ground. In addition, representation of a current in the form of a function of the distance L and observed magnetic-field intensity as variables and/or the like are acceptable without limitation to the case of storing the items of the information in the table.

The current calculation device 28 detects generation of a lightning strike in response to an event in which the synthetic magnetic-field intensity H = $\sqrt{(Hns^2 + Hew^2)}$ stored in the storage device 24 exceeds a reference value or to information from the outside. Before the synthetic magnetic-field intensity is detected exceeding the reference value, any one of the magnetic-field intensity Hns or Hew may be detected exceeding the reference value. The current calculation device 28 specifies data from the generation to end of the lightning strike, from the magnetic-field intensity stored in the storage device 24, when detecting the generation of the lightning strike. Then, the current calculation device 28 allows the ionosphere information gathering device 26 to gather information representing the state of the ionosphere. In addition, the current calculation device 28 determines the distance L between the installation point P1 of the magnetic field measurer 10 and the lightning strike generation point P3 by the distance determination device 25. Then, the current calculation device 28 determines a magnetic field-current ratio corresponding to the state of the ionosphere and to the distance L from the magnetic field-current ratio table 27 based on the state of the ionosphere and on the distance L. The current calculation device 28 sequentially reads the synthetic magnetic-field intensity H = $\sqrt{(Hns^2 + Hew^2)}$ from the generation to end of the lightning strike from the storage device 24 and multiplies the intensity by the magnetic field-current ratio to thereby sequentially determine the instantaneous values of a current passed by the lightning strike.

The multiplication device 29 multiplies the values, determined by the current calculation device 28, by a correction coefficient K, to thereby correct the current values determined by the current calculation device 28 to current values in a case in which the discharge path for a lightning strike is vertical to the ground.

The correction coefficient K is represented by the following expression:

$$K = (\text{true length of discharge path}/DL) * \cos \theta$$

in which the true length of the discharge path is determined and pre-set by statistical processing, a simulation, and/or the like based on a region in which the lightning strike is generated, weather conditions, and the like.

DL is the length of the discharge path, assumed when the magnetic field-current ratio R stored in the magnetic field-current ratio table 27 is determined.

$\theta$ is the inclination angle of the discharge path for a lightning strike. $\theta$ is determined by statistical processing, a simulation, and/or the like based on the region in which the lightning strike is generated, the weather conditions, and the like.

In addition, the coefficient K may also be represented in the form of a table or a function of a region and weather conditions as parameters.

The integration device 30 totalizes the results (corrected instantaneous values of current) of the operation of the multiplication device 29, to thereby integrate the current from the start to end of the lightning strike and to determine the electric charge Q passed by the lightning strike.

The above-mentioned electric charge calculator 20 is implemented by a computer comprising a CPU (Central Processing Unit) 201, a memory 202, an input device 203, a communication device 204, an output device 205, the A/D converter 21, the RTC 23, and the like in view of hardware, as illustrated in FIG. 2.

The memory 202 stores magnetic field data observed in the storage device 24 as well as an operation program and the like, and further functions as a work area for the CPU 201.

The CPU 201 executes the operation program stored in the memory 202 and executes processing in each device.

The input device 203 takes the magnetic-field components Hns and Hew output by the A/D converter 21.

The communication device 204 communicates with external devices via a network and takes the generation of the lightning strike, information for specifying the lightning point, ionosphere information, and the like.

The output device 205 outputs the determined electric charge Q of the lightning strike.

The operation of detecting (measuring) an electric charge caused by a lightning strike by the system 100 for estimating the electric charge of a lightning strike comprising the configuration described above will be explained below.

The magnetic field measurer 10 always measures a magnetic-field component Hns in the north-south direction and a magnetic-field component Hew in the east-west direction and supplies measurement data to the electric charge calculator 20.

The A/D converter 21 in the electric charge calculator 20 samples the magnetic-field components Hns and Hew, observed in the magnetic field measurer 10, at a constant sampling frequency, converts the magnetic-field components into digital data, and outputs the digital data. The digital data is accumulated and stored in the memory 202 functioning as the storage device 24 via the input device 203.

The CPU 201 extracts and outputs a low-frequency component at not more than a cut-off frequency (= 200 Hz) from the magnetic-field components Hns and Hew output from the A/D converter 21, as the low-pass filter 22.

The CPU 201 further accumulates the values of the magnetic-field components Hns and Hew passing through the low-pass filter 22, together with a current date and time measured by the RTC 23, in the memory 202 functioning as the storage device 24, as illustrated in FIG. 3. In this case, the CPU 201 determines the magnitude of a synthetic magnetic field, $H = \sqrt{(Hns^2 + Hew^2)}$, and stores the magnitude together.

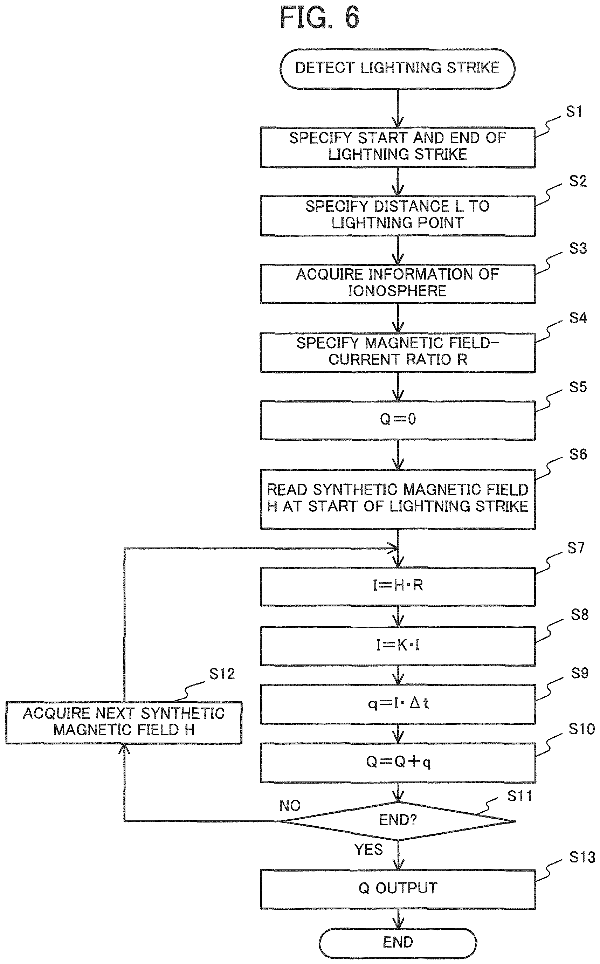

In parallel with the accumulation of the magnetic field data in the memory 202, the CPU 201 monitors the accumulated synthetic magnetic field. When the value of the synthetic magnetic field exceeds a threshold value, the CPU 201 determines that a lightning strike is generated, and executes processing of determining a lightning point and an electric charge, as illustrated in FIG. 6. In addition, the CPU 201 starts similar processing when being notified of the generation of the lightning strike from the external devices via the communication device 204.

First, the CPU 201 specifies the start and end of the lightning strike based on a change of the intensity H of the synthetic magnetic field, and/or the like as the current calculation device 28 (step S1).

Then, the CPU 201 determines the direction of the lightning point ($\varphi = \tan^{-1} (Hns/Hew)$) from a ratio (Hns/Hes) between the magnetic-field intensity Hns in the north-south direction and the magnetic-field intensity Hew in the east-west direction in a case in which the intensity of the synthetic magnetic field is not less than a reference level, as the distance determination device 25. The CPU 201 determines the lightning point P3 to determine the distance L to the installation site P2 of the magnetic field measurer 10 using the triangulation technique illustrated in FIG. 4, and the like, in cooperation with the other devices (step S2).

In addition, the CPU 201 accesses the outside via the communication device 204 and gathers information representing the information of the ionosphere (step S3).

Then, the CPU 201 determines a magnetic field-current ratio R corresponding to the state of the ionosphere and the distance L from the magnetic field-current ratio table 27 stored in the memory 202 (step S4).

In addition, the electric charge Q is initialized (step S5).

Then, the CPU 201 sequentially reads the intensity H of the synthetic magnetic field at the start of the lightning strike from the memory 202 (step S5) and determines a product H·R with the magnetic field-current ratio R (step S7). The product represents the average value I of the current passed due to the lightning strike at the start of the lightning strike.

Further, the CPU 201 multiplies the determined value I of the current by the correction coefficient K, as the multiplication device 29. As a result, a current value I in which the length unevenness and inclination of the discharge path are corrected is determined (step S8).

Further, the CPU 201 multiplies the determined value I of the current by a sampling period $\Delta t$. As a result, an electric charge q passing in the sampling period $\Delta t$ is determined (step S9).

Further, the CPU 201 totalizes the outputs from the multiplication device 29 to determine an electric charge Q caused by the lightning strike, as the integration device 30 (step S10).

Then, the CPU 201 determines whether or not the processing is finished up to the measurement magnetic field H at the end of the lightning strike. When the processing is not finished (step S11; No), the CPU 201 reads the intensity H of a synthetic magnetic field in the next sampling period targeted for processing (step S12), returns to step S7, and carries out similar processing.

When it is determined in step S11 that the processing is finished (step S11, Yes), the determined electric charge Q caused by the lightning strike is output (step S13).

According to the present embodiment, a lightning location can be specified and an electric charge passed due to a lightning strike can be determined in such a manner.

In the system 100 for estimating the electric charge of a lightning strike, the sensitivity of the magnetic field measurer 10 can also be set at 100 Hz or less. However, it is desirable for preventing the precision of the estimation of the electric charge from deteriorating that the magnetic field measurer 10 in itself has a sensitivity of around 200 Hz.

The cut-off frequency of the low-pass filter 22 can also be set at 200 Hz. The low-pass filter 22 may also be placed as an analog filter at the front of the A/D converter 21.

Acceptable is such a configuration that a lightning location specification function is removed from the distance determination device 25 and the information of the lightning location is received from the outside, for example, from an external lightning location system.

The example in which the electric charge calculator 20 comprises the digital circuits (computers) is described. However, the electric charge calculator 20 may comprise an analog circuit.

The measurement data of the magnetic field stored in the storage device 24 may show a polarity opposite to that in an early stage. For example, the measurement data may show a positive polarity in the early stage and subsequently show a negative polarity. One of the causes thereof is in that the sensitivity of the magnetic field measurer 10 in a low-frequency side is low. When such an event occurs, the sensitivity in the low-frequency side may be corrected to reduce a signal with an opposite polarity and to then determine an electric charge. The sensitivity of the magnetic field measurer 10 in the low-frequency region may also be improved.

"State of ionosphere" registered in the magnetic field-current ratio table 27 is optional. For example, "state of ionosphere" may be classified into, for example, "daytime state" and "night state". The magnetic field-current ratio R may also be set substantially based only on a distance in one kind of the state of the ionosphere. In such an environment that a distance can be considered to be constant, the magnetic field-current ratio R may also be set based only on the state of the ionosphere. In other words, in the magnetic field-current ratio table 27, the magnetic field-current ratio R may be set based on at least one of "state of ionosphere" and the distance.

The example in which the location of a lightning strike is estimated in the principle of the triangulation is described as a technique for specifying a lightning point. However, without limitation to the example, when there are three or more magnetic field measurement points, the location of a lightning strike may be determined by a general arrival time interval method based on a magnetic field reception time interval at each magnetic field measurement point. The location of a lightning strike may also be determined using both of the bearing of the lightning strike viewing from a magnetic field measurement point and a magnetic field receipt time interval. In the case of a lightning strike to a power transmission line, the location of failure due to the lightning strike may also be regarded as the location of the lightning strike. In the system for estimating the electric charge of a lightning strike of the embodiment of the present disclosure, a distance between the location of a lightning strike, determined in such a manner, and a magnetic field measurement point can be determined. In addition, the combination of the information of the determined distance to the magnetic field measurement point and the electric charge of the lightning strike, estimated by the electric charge calculation means, enables potential damage caused by the lightning strike, such as the erosion of the power transmission line, to be estimated and a material for judging the need of measures against damage to be provided.

Before starting the processing of step S6 of FIG. 6, the CPU 201 may also check the waveform of the magnetic field stored in the memory 202 to determine whether a portion of a polarity opposite to an initial polarity is present or not, and may execute processing of correcting the portion of the opposite polarity so as to be, for example, reduced when determining that the portion of the opposite polarity is present. The conversion characteristics of the A/D converter 21 or the characteristics of the low-pass filter 22 may also be changed so that a larger amount of a low-frequency component is included in the stored magnetic field waveform when the CPU 201 detects the portion of the opposite polarity.

With regard to the system for estimating the electric charge of a lightning strike of the embodiment of the present disclosure, observation of a lightning strike and a simulation of an electromagnetic field caused by the lightning strike were performed to examine the configuration and effect thereof. In addition, a specific technique for determining the electric charge of a lightning strike from a measured magnetic field waveform was examined.

[Observation of Lightning Strike]

A certain lightning strike was observed with a Rogowski coil and a search coil magnetic field meter. The Rogowski coil is installed in Mt. Ogami in Niigata, Japan, and is capable of observing a current waveform passing through an electric wave tower in a frequency band of 0.1 Hz to 1 MHz. The observed current waveform is sampled at 1 $\mu$s and time-stamped with a GPS clock. The lightning strike used for the observation occurred in Mt. Ogami and passed through an electric wave tower in Mt. Ogami.

The search coil magnetic field meter (magnetic field measurer 10 of the embodiment) is installed in the Onagawa observatory (Onagawa) in Miyagi, 296 km apart from Mt. Ogami, and is capable of observing a lightning discharge electromagnetic field pulse in a frequency band of 2 to 90 Hz. The search coil magnetic field meter is configured to observe two horizontal components in the geographical north-south and east-west directions. An observed electric field waveform is discretized and recorded at a resolution of 16 bits.

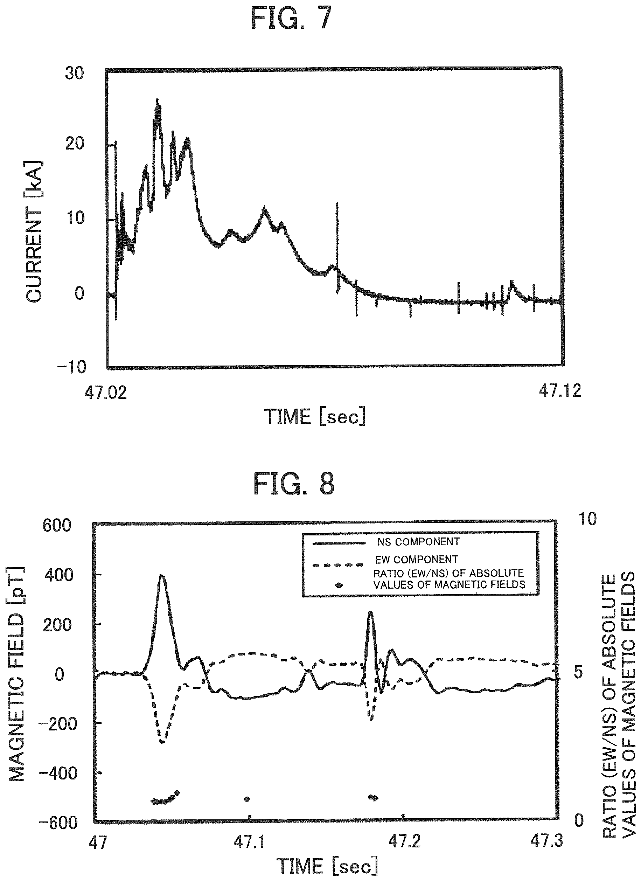

The current waveform observed in Mt. Ogami, illustrated in FIG. 7, has a frequency band restricted to 90Hz or less in order to be compared with the magnetic field waveform observed with the search coil magnetic field meter. As illustrated in FIG. 7, the current is little changed, then increased to a maximum value of 26 kA, and then attenuated. In this case, the integration of the current is equivalent to the electric charge passed by the lightning strike. The electric charge of the portion of the first positive polarity of the lightning strike illustrated in FIG. 7 is 474 C, and the portion of the following negative polarity is -496 C. Assuming that the portion of the negative polarity of the current waveform is due to the insufficient sensitivity of the Rogowski coil in a low frequency, it is estimated the actual electric charge caused by the lightning strike is about 540 C, which is slightly more than that of the portion of the former positive polarity.

FIG. 8 illustrates the waveforms of the magnetic-field components, observed in the Onagawa observatory due to the same lightning strike generated in Mt. Ogami. The polarity in the south-west direction is positive. The waveforms of both components are similar, and the ratio of the EW-direction component to the NS-direction component is about 0.70, as illustrated by the black circles of FIG. 8, when the absolute value of the NS-direction component is more than 100 nT. The incidence azimuth of an electromagnetic pulse based on the ratio is 54.8° west with respect to the south and is similar to the bearing of the Mt. Ogami although deviating slightly toward the south with respect to the bearing of the Mt. Ogami. It is estimated that the slight deviation of the bearing is caused mainly by the installation of the transverse magnetic field meter (magnetic field measurer 10), for example, the rotation of a magnetic field meter set in a horizontal plane or the calibration error of sensitivity. It can also be considered that there is the influence of induction noise at 50 Hz, caused by a power line. In such a manner, the bearing of the lightning strike can be determined based on the waveform of each component of the magnetic field.

The precision of the measurement of a lightning location can be enhanced by combining the bearing of the lightning strike, determined based on the waveform of each component of the magnetic field, with the lightning location system and/or the like. The location of the lightning strike can also be determined by determining the bearing of the lightning strike at a plurality of locations.

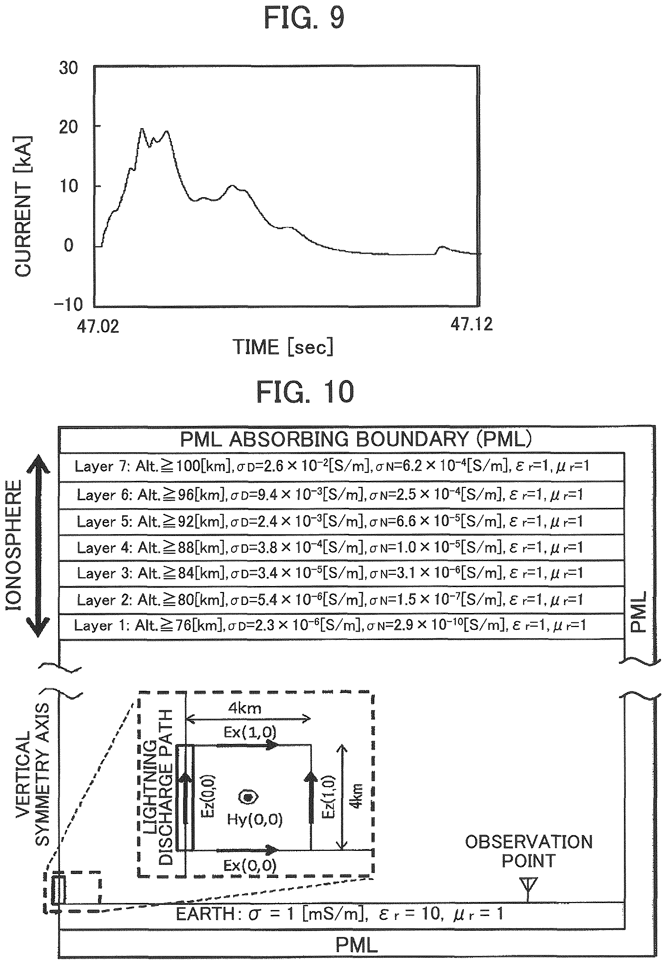

In order to compare the current waveform illustrated in FIG. 7 with the magnetic field waveforms illustrated in FIG. 8, the current waveform was filtered (attenuation factor: -6 dB/ octave) at a cut-off frequency of 90 Hz in a high-frequency side in accordance with an observed magnetic field frequency band of 2 to 90 Hz in the Onagawa observatory. A waveform subjected to the application of the filtering is illustrated in FIG. 9. As illustrated in FIG. 9, it was confirmed that the obtained waveform coincides well with the magnetic field waveforms illustrated in FIG. 8 except the differences in amplitudes and polarities. This shows that the magnetic field waveforms illustrated in FIG. 8 mainly comprise induction components caused by the lightning current. Thus, it can be considered that the current waveform of lightning can be determined based on a magnetic field waveform observed in a low-frequency band. The current waveform can be integrated to thereby determine an electric charge passed due to a lightning strike and to estimate the electric charge of the lightning strike.

[Simulation of Electromagnetic Field Caused by Lightning Strike]

Simulated was an electromagnetic field in a case in which an electromagnetic pulse caused by lightning radially propagates under the ionosphere. In the simulation, the FDTD method (finite difference time domain method) applied to simulations of electromagnetic fields caused by lightning in various situations was used. In addition, a cylindrical coordinate system was used as a coordination system. A discharge path was made to be simple so as to be vertical to the earth, and an axial target condition in the cylindrical coordinate system was applied. In addition, it was assumed that the earth and the ionosphere with a plural-layer structure were horizontally parallel plates. The current waveform illustrated in FIG. 9 was used as an input current waveform.

FIG. 10 illustrates a schematic diagram of a cylindrical coordinate system FDTD simulation for reproducing the propagation of an electromagnetic pulse under the ionosphere at 296 km from lightning generated in Mt. Ogami to the Onagawa observatory. As illustrated in FIG. 10, the simple lightning discharge path having a length of 4 km is installed along the vertical axis in the center of a simulation space on the surface of the earth. In addition, the electromagnetic field of the simulation space is excited by a horizontal magnetic field placed in a magnetic field element Hy (0, 0) at a radius of 2 km around the discharge path. In the simulation, a current with a positive polarity, passing downward along the discharge path, generates a positive horizontal magnetic field in Hy (0, 0). It was assumed that the conductivity of the earth was uniformly 1 mS/m. The ionosphere comprises seven horizontal layers, and different conductivities (σD, σN) between daytime and night were set in each layer. However, a relative dielectric constant εr and a relative magnetic permeability μr were set at the same levels as those in a vacuum. The simulation space is surrounded by a PML absorbing boundary, and the wall of the end thereof is separated so that reflection on the wall is prevented from influencing an observation point.

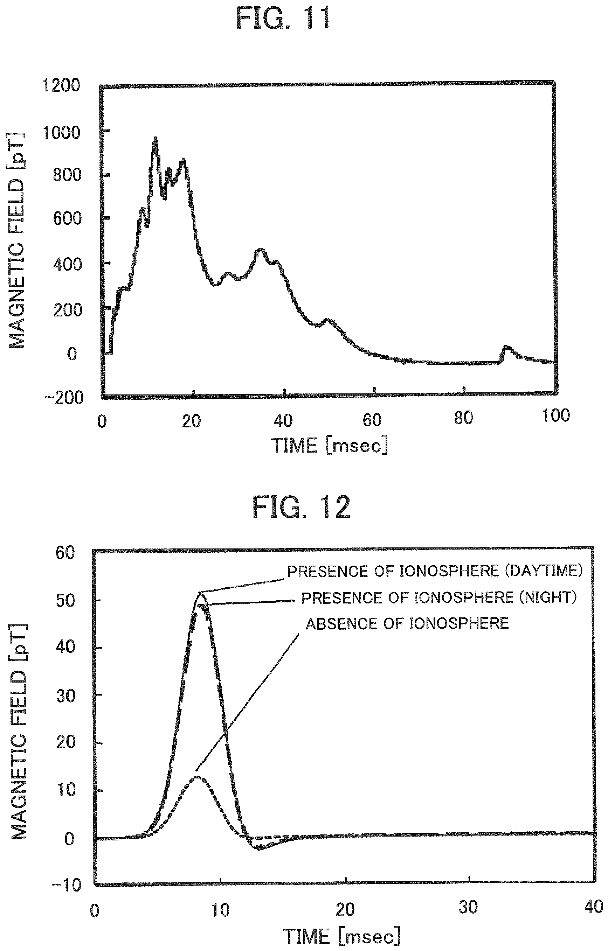

FIG. 11 illustrates the simulation result of a horizontal magnetic field waveform at a distance of 298 km from the lightning, corresponding to an Onagawa observation point. It is shown that the waveform illustrated in FIG. 11 resembles the waveform of FIG. 9 closely, and most of the waveform is occupied by an induction field. This is because a propagation distance is much shorter than a wavelength of an electric wave of 3300 km at 90 Hz. In addition, the deflections of the first pulses of the magnetic field waveforms illustrated in FIG. 8 toward negative polarity are deeper than the deflection of the magnetic field waveform in the simulation illustrated in FIG. 11 toward negative polarity. This is because a cut-off frequency in a low-frequency side in magnetic field observation is 2 Hz, which is higher than a cut-off frequency of 0.1 Hz in a low region in current observation.

In addition, as illustrated in FIG. 11, the peak value of the magnetic field obtained by the simulation was about 800 pT when a change in high frequencies, which was not seen in the observed waveform, was ignored. The observed peak value of the magnetic field comprised an NS-direction component and an EW-direction component and was 480 pT. The observed peak value is as low as 0.6 which is a peak value obtained by the simulation. It is estimated that an actual discharge path length is 2.4 km assuming that the amplitude of the magnetic field is proportional to the length of the discharge path. In order to a current is estimated from a magnetic field, reference to a discharge path length obtained by other observation of a lightning strike may be made.

In order to investigate the influence of the ionosphere on the propagation of an electromagnetic pulse, magnetic fields caused by simple current pulses were determined at different distances. It was assumed that the lightning current was a Gaussian pulse with a peak half height width of 1, 2, or 4 ms at a peak value of 1 kA. The rising frequency of the Gaussian pulse is about 400, 200, or 100 Hz.

FIG. 12 illustrates horizontal magnetic field waveforms at a propagation distance of 298 km, obtained by the simulation assuming that the lightning current is the Gaussian pulse with a peak half height width of 4 ms. As illustrated in FIG. 12, the magnetic field waveforms obtained by the simulation resemble the current waveform closely, regardless of the presence or absence of the ionosphere except slight deflection toward negative polarity. This shows that the current waveform and the magnetic field waveforms are similar. The signal strength of the waveform of the electromagnetic fields propagating under the ionosphere during daytime or night is 4.3 times or 4.1 times those in the absence of the ionosphere.

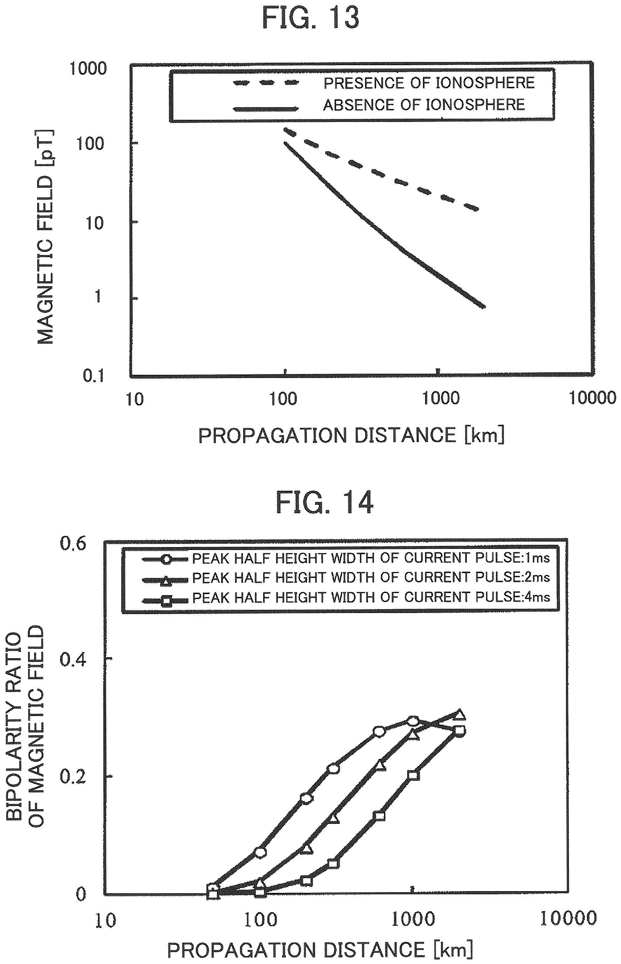

FIG. 13 illustrates relationships between the logarithmic peak values of horizontal magnetic field pulses and logarithmic propagation distances, obtained by the simulation on the same conditions as those of FIG. 12. As illustrated in FIG. 13, the peak values are attenuated with increasing the propagation distances regardless of the presence or absence of the ionosphere. The average attenuation factors thereof were -0.8 in the presence of the ionosphere and -1.6 in the absence of the ionosphere. This shows that the ionosphere has the effect of reducing the attenuation of the magnetic field, depending on the distance, in the absence of the ionosphere, to about 1/10. As illustrated in FIG. 13, the attenuation factor of the peak value of the magnetic field was 1.8 in the propagation between Mt. Ogami and the Onagawa observatory in the absence of the ionosphere. In this case, a vertical electric dipole, which is a perfect conductor, on the ground generates a horizontal magnetic field on the surface of the earth, and the induction and radiation components of the magnetic field are attenuated inversely with the square and one power of a distance from the dipole, respectively. In addition, the actual attenuation of a magnetic field is a mixture of the attenuations of both components. Thus, most of the magnetic field propagating between Mt. Ogami and the Onagawa observatory is considered to comprise the induction component with the attenuation suppressed by the ionosphere.

FIG. 14 illustrates the propagation distance dependency of the bipolarity ratios of the magnetic field pulses, obtained by the simulation, with varying the peak half height width of a current pulse. As used herein, the bipolarity ratio of a magnetic field pulse is the absolute value of the ratio of a following peak in negative polarity to the first peak of a magnetic field waveform. In addition, FIG. 14 illustrates simulation results during daytime in the presence of the ionosphere. As illustrated in FIG. 14, the bipolarity ratio is increased to about 0.3 with increasing a propagation distance. In addition, when the peak half height width of the current pulse is increased, a parallel displacement of a bipolarity ratio curve occurs toward a longer propagation distance. On conditions where the ionosphere is not present, the bipolarity ratio of the magnetic field pulse approaches 1 with increasing the propagation distance, and therefore, it is found that the increase of the bipolarity ratio is suppressed by the effect of the ionosphere.

Assuming that the magnetic field pulse obtained by the simulation is observed in the Onagawa observatory, the bipolarity ratio is about 5% based on FIG. 14 since the peak half height width of the current pulses is 4 ms equivalent to a cut-off frequency of 90 Hz and a propagation distance is 296 km. This shows that a difference between a current waveform and the waveform of the magnetic field pulse is small. Based on FIG. 14, it can be considered that the slight deflection toward the negative polarity after the peak of the magnetic field waveform can be improved by extending the low region of observation frequencies, to thereby allow the magnetic field waveform and the current waveform to coincide better with each other.

An original lightning current waveform can be easily reproduced from the magnetic field waveform in the ranges of frequencies and a propagation distance in which the bipolarity ratio indicated in FIG. 14 is sufficiently low. An electric charge associated with the damage of a facility, caused by lightning, can be estimated with high precision by such a reproduced current waveform comprising a low-frequency component. In other words, the electric charge passed due to a lightning strike can be estimated by integrating the reproduced current waveform. The combination of the estimated electric charge of the lightning strike and the information of a lightning location determined by a lightning location system (LLS) or the like enables potential damage caused by the lightning strike, such as the erosion of a power transmission line, to be estimated and a material for judging the need of measures against damage to be provided.

When a bipolarity ratio of up to 5% is permitted for reproducing the original lightning current waveform from the magnetic field waveform, an observed frequency is 100 Hz or less and an observation distance is 300 km or less in the case of a peak half height width of 4 ms, an observation frequency is 200 Hz or less and an observation distance is 150 km or less in the case of a peak half height width of 2 ms, and an observation frequency is 400 Hz or less and an observation distance is 70 km or less in the case of a peak half height width of 1 ms, based on FIG. 14. In addition, when a bipolarity ratio of up to 10% is permitted, an observation frequency is 100 Hz or less and an observation distance is 400 km or less in the case of a peak half height width of 4 ms, an observation frequency is 200 Hz or less and an observation distance is 250 km or less in the case of a peak half height width of 2 ms, and an observation frequency is 400 Hz or less and an observation distance is 150 km or less in the case of a peak half height width of 1 ms. Further, when a bipolarity ratio of up to 20% is permitted, an observation frequency is 100 Hz or less and an observation distance is 1000 km or less in the case of a peak half height width of 4 ms, an observation frequency is 200 Hz or less and an observation distance is 500 km or less in the case of a peak half height width of 2 ms, and an observation frequency is 400 Hz or less and an observation distance is 300 km or less in the case of a peak half height width of 1 ms.

Since the current waveform is integrated to determine the electric charge, the rapid change (high-frequency component) of the current does not influence the electric charge. Therefore, a time resolution of several tens of ms is considered to be sufficient in consideration of integration of the current waveform for duration time of the order of several hundreds of ms. Thus, for example, an observation frequency is about 25 Hz or less assuming that a current pulse width is around 10 ms, and the observation distance of an induction field is 800 km to 1000 km or less assuming that a permissible bipolarity ratio is 5%. In this case, for example, the whole of Japan can be covered by three observation points.

[Examination of Specific Technique for Determining Electric Charge of Lightning Strike]

A specific technique for determining the electric charge of a lightning strike from a measured magnetic field waveform was examined based on the results of the observation of the lightning strike and the simulation of the electromagnetic field caused by the lightning strike, as described above. First, a distance from the location of the lightning strike, determined utilizing bearing estimation means, a lightning location system, or the like to a magnetic field measurement point with magnetic field measurement means is determined, and the ratio of a lightning current to the magnitude of a magnetic field at the distance is determined based on FIG. 13. A magnetic field waveform measured by the magnetic field measurement means, as illustrated in FIG. 8, is multiplied by the ratio to obtain a lightning current waveform at a discharge path length of 4 km.

The obtained lightning current waveform is multiplied by the ratio of the true length of the discharge path/4 km to obtain a lightning current waveform in a case in which the discharge path is vertical. In this case, the true length of the discharge path can be obtained with reference to a discharge path length obtained by observation of another lightning strike. Further, the obtained lightning current waveform is multiplied by $1/\cos\theta$ ($\theta$ is inclination angle of discharge path) to obtain the waveform of a lightning current passing through an inclined discharge path. In this case, $\theta$ can be obtained with reference to an average value obtained in observation.

Since the relationship between a lightning current waveform and a magnetic field waveform includes distortion, the lightning current waveform with high reliability can be estimated by utilizing the magnetic field waveform observed at a point with small distortion based on FIG. 14. An electric charge passing through the earth due to a lightning strike can be determined by integrating the current waveform of the lightning strike, obtained in such a manner.

According to the above procedure, the electric charge of the lightning strike was actually estimated from the magnetic field waveforms of FIG. 13. The peak value of the NS-direction component of the observed magnetic field illustrated in FIG. 13 was 390 pT, and the peak value of the EW-direction component thereof was 270 pT. Based on the results, it is calculated that the peak value of the synthetic magnetic field determined from the square root of the sum of the square of the NS-direction component and the square of the EW-direction component is 480 pT. Based on FIG. 13, a magnetic field observed in the Onagawa observatory at a distance of 296 km from Mt. Ogami is 50 pT when the discharge path length of a lightning strike generated in Mt. Ogami is 4 km and a current value is 1 kA. It is calculated from the relationship that a current value is 1 kA × 480 pT / 50 pT = 10 kA. Assuming that a discharge path length is 3 km which is the average discharge path length of lightning in the winter season in an area including Mt. Ogami and that the average inclination of the discharge path is 45°, it is estimated that a vertical equivalent discharge path length for generating a magnetic field is 3 km/$\sqrt{2}$ = about 2.1 km. It is estimated that a current peak value is 10 kA × 4 km/2.1 km = 19 kA based on the ratio between the length and an assumed discharge path length of 4 km. The value is nearly equal to an actual current peak value of 18 kA illustrated in FIG. 9. Similarly, when the magnetic field waveform illustrated in FIG. 11 is converted into a current waveform, which is integrated, an electric charge of 530 kA is calculated. The value is nearly equal to an electric charge of 540 kA obtained by the integration of the current waveform illustrated in FIG. 9.

Based on the above discussion, it was confirmed that the electric charge of a lightning strike can be appropriately estimated by the system 100 for estimating the electric charge of a lightning strike according to the embodiment of the present application.

The present disclosure is not limited to the embodiment described above, and various changes and applications may be made.

For example, the operation program stored in the memory 202 may be stored in a non-transitory computer-readable recording medium such as a flexible disk, a CD-ROM (Compact Disk Read-Only Memory), a DVD (Digital Versatile Disk), or MO (Magneto-Optical disk), and may be distributed. The functions of the system for estimating an electric charge can also be implemented by installing the operation program on a computer.

The program, stored in a disk device and/or the like included in a predetermined server device on a communication network such as the Internet and superimposed on, for example, a carrier wave, may also be downloaded to a computer.

The above-mentioned functions can also be achieved by starting and executing the program while transferring the program via a communication network.

Further, the above-mentioned functions can also be achieved by executing the whole or a part of the program on a server device and allowing a computer to execute the program while sending and receiving information on the processing via a communication network.

In a case in which the above-mentioned functions are shared and implemented by OSes (Operating Systems), a case in which the above-mentioned functions are implemented in cooperation of an OS and an application, or the like, only the portion other than the OSes, stored in a medium, may be distributed, or the portion may be downloaded to a computer.

The present application is based on Japanese Patent Application No. 2012-251493 filed on November 15, 2012.

Industrial Applicability

The present disclosure can be widely utilized in the case of estimating the electric charge of a lightning strike.

Reference Signs List

| 10 | Magnetic field measurer |
|----|---------------------------|
| 20 | Electric charge calculator |
| 21 | A/D converter |
| 22 | Low-pass filter (LPF) |
| 23 | RTC |
| 24 | Storage device |
| 25 | Distance determination device |
| 26 | Ionosphere information gathering device |
| 27 | Magnetic field-current ratio table |
| 28 | Current calculation device |
| 29 | Multiplication device |
| 30 | Integration device (totalization device) |
| 100 | System for estimating electric charge of lightning strike |

201   CPU
202   Memory
203   Input device
204   Communication device
205   Output device

**Claims**

1.  A system (100) for estimating an electric charge of a lightning strike having a discharge path, comprising:

    magnetic field measurement means (10) configured to measure a magnetic field generated by the lightning strike in a frequency band of 200 Hz or less; and
    electric charge calculation means (20) configured to determine a current of the lightning strike based on the magnetic field measured by the magnetic field measurement means, and to integrate the current to determine an electric charge;
    wherein the electric charge calculation means comprises:

    means (28) configured to determine the current of the lightning strike by multiplying the measured magnetic field by a magnetic field-current conversion coefficient for a case where a discharge path has a reference length and is vertical to the ground;
    means (29) configured to multiply the determined current by a correction coefficient based on estimated values of a length and inclination of the discharge path of the lightning strike; and
    integration means (30) configured to integrate the current multiplied by the correction coefficient.

2.  The system for estimating an electric charge of a lightning strike according to claim 1, wherein:

    the inclination of the discharge path is expressed by a cosine value of an angle made by an extending direction of the discharge path and the vertical direction; and
    the correction coefficient is based on:

    a ratio of the estimated value of the length of the discharge path to the reference length; and
    the estimated value of the cosine value.

3.  The system for estimating an electric charge of a lightning strike according to claim 1 or 2, wherein:
    the estimated value of the length of the discharge path is estimated from a length of a discharge path acquired by another lightning strike observation.

4.  The system for estimating an electric charge of a lightning strike according to any one of claims 1 to 3, wherein the magnetic field measurement means (20) is configured to measure a magnetic field generated by a lightning strike in a frequency band of 100 Hz or less.

5.  The system for estimating an electric charge of a lightning strike according to any one of claims 1 to 4, further comprising filter means (22) for filtering the magnetic field, measured by the magnetic field measurement means (10), at a cut-off frequency of 100 Hz on a high frequency side,
    wherein the electric charge calculation means (20) is configured to determine an electric charge based on the magnetic field filtered by the filter means.

6.  The system for estimating an electric charge of a lightning strike according to any one of claims 1 to 5, wherein
    the magnetic field measurement means (10) is configured to measure two quadrature components of a magnetic field generated by a lightning strike; and
    the system further comprises bearing estimation means configured to determine a direction of the lightning based on each component of the magnetic field measured by the magnetic field measurement means (10).

7.  The system for estimating an electric charge of a lightning strike according to any one of claims 1 to 6, wherein the magnetic field measurement means (10) comprises a low-frequency region in a frequency band of a measurement target so that the measured magnetic field excludes a value of a polarity opposite to an initial polarity.

8. The system for estimating an electric charge of a lightning strike according to any one of claims 1 to 7, wherein the electric charge calculation means (20) is configured to make a correction so that a magnetic field or a current determined based on the magnetic field excludes a value of a polarity opposite to an initial polarity, followed by determining the electric charge.

9. The system for estimating an electric charge of a lightning strike according to any one of claims 1 to 8, wherein the magnetic field-current conversion coefficient is set in consideration of at least one of attenuation of a magnetic field, depending on a distance between a lightning point and a magnetic field measurement point, and attenuation of a magnetic field, depending on a state of an ionosphere.

10. A method for estimating an electric charge of a lightning strike having a discharge path, comprising:

measuring a magnetic field generated by the lightning strike in a frequency band of 200 Hz or less;
determining a current of the lightning strike by multiplying the measured magnetic field by a magnetic field-current conversion coefficient for a case where a discharge path has a reference length and is vertical to the ground;
multiplying the determined current by a correction coefficient based on estimated values of a length and inclination of the discharge path of the lightning strike; and
integrating the current multiplied by the correction coefficient to determine an electric charge caused by the lightning strike.

11. A computer program allowing a computer to execute:

determining a current of a lightning strike having a discharge path based on a measured magnetic field in a frequency of 200 Hz or less by multiplying the measured magnetic field by a magnetic field-current conversion coefficient for a case where a discharge path has a reference length and is vertical to the ground;
multiplying the determined current by a correction coefficient based on estimated values of a length and inclination of the discharge path of the lightning strike; and
integrating the current multiplied by the correction coefficient to determine an electric charge caused by the lightning strike.

**Patentansprüche**

1. System (100) zum Schätzen einer elektrischen Ladung eines Blitzschlags mit einem Entladungspfad, umfassend:

ein Magnetfeldmessmittel (10), konfiguriert, ein von dem Blitzschlag in einem Frequenzband von 200 Hz oder weniger erzeugtes Magnetfeld zu messen; und
ein Elektrische-Ladung-Berechnungsmittel (20), konfiguriert, eine Stromstärke des Blitzschlags auf Basis des von dem Magnetfeldmessmittel gemessenen Magnetfelds zu bestimmen und die Stromstärke zu integrieren, um eine elektrische Ladung zu bestimmen;
wobei das Elektrische-Ladung-Berechnungsmittel umfasst:

ein Mittel (28), das dazu konfiguriert ist, durch Multiplizieren des gemessenen Magnetfelds mit einem Magnetfeld-Stromstärke-Umrechnungskoeffizienten für einen Fall, in dem der Entladungspfad eine Referenzlänge hat und senkrecht zum Boden ist, die Stromstärke des Blitzschlags zu bestimmen;
ein Mittel (29), konfiguriert, die bestimme Stromstärke mit einem Korrekturkoeffizienten zu multiplizieren, basierend auf Schätzwerten einer Länge und Neigung des Entladungspfads des Blitzschlags; und
ein Integrationsmittel (30), konfiguriert, die mit dem Korrekturkoeffizienten multiplizierte Stromstärke zu integrieren.

2. System zum Schätzen einer elektrischen Ladung eines Blitzschlags gemäß Anspruch 1, wobei:

die Neigung des Entladungspfads durch einen Kosinuswert eines Winkels ausgedrückt wird, gebildet durch eine Erstreckungsrichtung des Entladungspfads und der senkrechten Richtung; und
der Korrekturkoeffizient basiert auf:

einem Verhältnis des Schätzwerts der Länge des Entladungspfads zur Referenzlänge; und

dem Schätzwert des Kosinuswerts.

3. System zum Schätzen einer elektrischen Ladung eines Blitzschlags gemäß Anspruch 1 oder 2, wobei:
der Schätzwert der Länge des Entladungspfads aus einer Länge eines durch eine andere Blitzschlagbeobachtung erhaltenen Entladungspfads geschätzt wird.

4. System zum Schätzen einer elektrischen Ladung eines Blitzschlags gemäß einem der Ansprüche 1 bis 3, wobei das Magnetfeldmessmittel (20) konfiguriert ist, ein von einem Blitzschlag in einem Frequenzband von 100 Hz oder weniger erzeugtes Magnetfeld zu messen.

5. System zum Schätzen einer elektrischen Ladung eines Blitzschlags gemäß einem der Ansprüche 1 bis 4, ferner umfassend ein Filtermittel (22) zum Filtern des von dem Magnetfeldmessmittel (10) gemessenen Magnetfelds mit einer Grenzfrequenz von 100 Hz auf einer Hochfrequenzseite,
wobei das Elektrische-Ladung-Berechnungsmittel (20) konfiguriert ist, auf Basis des von dem Filtermittel gefilterten Magnetfelds eine elektrische Ladung zu bestimmen.

6. System zum Schätzen einer elektrischen Ladung eines Blitzschlags gemäß einem der Ansprüche 1 bis 5, wobei

das Magnetfeldmessmittel (10) konfiguriert ist, zwei Quadraturkomponenten eines von einem Blitzschlag erzeugten Magnetfelds zu messen; und
das System ferner ein Peilungs-Schätzmittel umfasst, konfiguriert, eine Richtung des Blitzes auf Basis jeder Komponente des von dem Magnetfeldmessmittel (10) gemessenen Magnetfelds zu bestimmen.

7. System zum Schätzen einer elektrischen Ladung eines Blitzschlags gemäß einem der Ansprüche 1 bis 6, wobei das Magnetfeldmessmittel (10) einen Niederfrequenzbereich in einem Frequenzband eines Messziels umfasst, sodass das gemessene Magnetfeld einen Wert einer Polarität ausschließt, die einer anfänglichen Polarität entgegengesetzt ist.

8. System zum Schätzen einer elektrischen Ladung eines Blitzschlags gemäß einem der Ansprüche 1 bis 7, wobei das Elektrische-Ladung-Berechnungsmittel (20) konfiguriert ist, eine Korrektur vorzunehmen, sodass ein Magnetfeld oder eine auf Basis des Magnetfelds bestimmte Stromstärke einen Wert einer Polarität ausschließen, die einer anfänglichen Polarität entgegengesetzt ist, gefolgt von einem Bestimmen der elektrischen Ladung.

9. System zum Schätzen einer elektrischen Ladung eines Blitzschlags gemäß einem der Ansprüche 1 bis 8,
wobei der Magnetfeld-Stromstärke-Umrechnungskoeffizient unter Berücksichtigung mindestens einer Dämpfung eines Magnetfelds, abhängig von einer Entfernung zwischen einem Blitzschlagpunkt und einem Magnetfeldmesspunkt, und einer Dämpfung eines Magnetfelds, abhängig von einem Zustand einer Ionosphäre, eingestellt wird.

10. Verfahren zum Schätzen einer elektrischen Ladung eines Blitzschlags, der einen Entladungspfad hat, umfassend:

Messen eines von dem Blitzschlag in einem Frequenzband von 200 Hz oder weniger erzeugten Magnetfelds;
Bestimmen einer Stromstärke des Blitzschlags durch Multiplizieren des gemessenen Magnetfelds mit einem Magnetfeld-Stromstärke-Umrechnungskoeffizienten für einen Fall, in dem der Entladungspfad eine Referenzlänge hat und senkrecht zum Boden ist;
Multiplizieren der bestimmen Stromstärke mit einem Korrekturkoeffizienten, der auf Schätzwerten einer Länge und Neigung des Entladungspfads des Blitzschlags basiert; und
Integrieren der mit dem Korrekturkoeffizienten multiplizierten Stromstärke zum Bestimmen einer von dem Blitzschlag verursachten elektrischen Ladung.

11. Computerprogramm, das es einem Computer ermöglicht, auszuführen:

Bestimmen einer Stromstärke eines Blitzschlags mit einem Entladungspfad, auf Basis eines gemessenen Magnetfelds in einer Frequenz von 200 Hz oder weniger durch Multiplizieren des gemessenen Magnetfelds mit einem Magnetfeld-Stromstärke-Umrechnungskoeffizienten für einen Fall, in dem der Entladungspfad eine Referenzlänge hat und senkrecht zum Boden ist;
Multiplizieren der bestimmen Stromstärke mit einem Korrekturkoeffizienten, basierend auf Schätzwerten einer Länge und Neigung des Entladungspfads des Blitzschlags; und
Integrieren der mit dem Korrekturkoeffizienten multiplizierten Stromstärke zum Bestimmen einer von dem Blitzschlag verursachten elektrischen Ladung.

**Revendications**

1. Système (100) destiné à estimer une charge électrique d'un foudroiement présentant un trajet de décharge, comprenant :

   un moyen de mesure de champ magnétique (10) configuré de manière à mesurer un champ magnétique généré par le foudroiement dans une bande de fréquence de 200 Hz ou moins ; et
   un moyen de calcul de charge électrique (20) configuré de manière à déterminer un courant du foudroiement sur la base du champ magnétique mesuré par le moyen de mesure de champ magnétique, et à intégrer le courant en vue de déterminer une charge électrique ;
   dans lequel le moyen de calcul de charge électrique comprend :

   un moyen (28) configuré de manière à déterminer le courant du foudroiement en multipliant le champ magnétique mesuré par un coefficient de conversion de champ magnétique-courant pour un cas où un trajet de décharge présente une longueur de référence et est vertical par rapport au sol ;
   un moyen (29) configuré de manière à multiplier le courant déterminé par un coefficient de correction basé sur des valeurs estimées d'une longueur et d'une inclinaison du trajet de décharge du foudroiement ; et
   un moyen d'intégration (30) configuré de manière à intégrer le courant multiplié par le coefficient de correction.

2. Système destiné à estimer une charge électrique d'un foudroiement selon la revendication 1, dans lequel :

   l'inclinaison du trajet de décharge est exprimée par une valeur de cosinus d'un angle formé par une direction d'extension du trajet de décharge et la direction verticale ; et
   le coefficient de correction est basé sur :

   un rapport entre la valeur estimée de la longueur du trajet de décharge et la longueur de référence ; et
   la valeur estimée de la valeur de cosinus.

3. Système destiné à estimer une charge électrique d'un foudroiement selon la revendication 1 ou 2, dans lequel :
   la valeur estimée de la longueur du trajet de décharge est estimée à partir d'une longueur d'un trajet de décharge acquise par une autre observation de foudroiement.

4. Système destiné à estimer une charge électrique d'un foudroiement selon l'une quelconque des revendications 1 à 3, dans lequel le moyen de mesure de champ magnétique (20) est configuré de manière à mesurer un champ magnétique généré par un foudroiement dans une bande de fréquence de 100 Hz ou moins.

5. Système destiné à estimer une charge électrique d'un foudroiement selon l'une quelconque des revendications 1 à 4, comprenant en outre un moyen de filtrage (22) pour filtrer le champ magnétique, mesuré par le moyen de mesure de champ magnétique (10), à une fréquence de coupure de 100 Hz côté haute fréquence ;
   dans lequel le moyen de calcul de charge électrique (20) est configuré de manière à déterminer une charge électrique sur la base du champ magnétique filtré par le moyen de filtrage.

6. Système destiné à estimer une charge électrique d'un foudroiement selon l'une quelconque des revendications 1 à 5, dans lequel
   le moyen de mesure de champ magnétique (10) est configuré de manière à mesurer deux composantes en quadrature d'un champ magnétique généré par un foudroiement ; et
   le système comprend en outre un moyen d'estimation de relèvement configuré de manière à déterminer une direction du foudroiement sur la base de chaque composante du champ magnétique mesuré par le moyen de mesure de champ magnétique (10).

7. Système destiné à estimer une charge électrique d'un foudroiement selon l'une quelconque des revendications 1 à 6, dans lequel le moyen de mesure de champ magnétique (10) comprend une région de basse fréquence dans une bande de fréquence d'une cible de mesure, de sorte que le champ magnétique mesuré exclut une valeur dont une polarité est opposée à une polarité initiale.

**8.** Système destiné à estimer une charge électrique d'un foudroiement selon l'une quelconque des revendications 1 à 7, dans lequel le moyen de calcul de charge électrique (20) est configuré de manière à effectuer une correction, de sorte qu'un champ magnétique ou un courant déterminé sur la base du champ magnétique exclut une valeur dont une polarité est opposée à une polarité initiale, ladite correction étant suivie d'une détermination de la charge électrique.

**9.** Système destiné à estimer une charge électrique d'un foudroiement selon l'une quelconque des revendications 1 à 8, dans lequel le coefficient de conversion de champ magnétique-courant est défini en tenant compte d'au moins une caractéristique parmi l'atténuation d'un champ magnétique, en fonction d'une distance entre un point d'éclair et un point de mesure de champ magnétique, et l'atténuation d'un champ magnétique, en fonction d'un état d'une ionosphère.

**10.** Procédé d'estimation d'une charge électrique d'un foudroiement présentant un trajet de décharge, comprenant les étapes ci-dessous consistant à :

mesurer un champ magnétique généré par le foudroiement dans une bande de fréquence de 200 Hz ou moins ; et déterminer un courant du foudroiement en multipliant le champ magnétique mesuré par un coefficient de conversion de champ magnétique-courant pour un cas où un trajet de décharge présente une longueur de référence et est vertical par rapport au sol ;
multiplier le courant déterminé par un coefficient de correction basé sur des valeurs estimées d'une longueur et d'une inclinaison du trajet de décharge du foudroiement ; et
intégrer le courant multiplié par le coefficient de correction en vue de déterminer une charge électrique occasionnée par le foudroiement.

**11.** Programme informatique permettant à un ordinateur d'exécuter les étapes ci-dessous consistant à :

déterminer un courant d'un foudroiement présentant un trajet de décharge sur la base d'un champ magnétique mesuré dans une fréquence de 200 Hz ou moins, en multipliant le champ magnétique mesuré par un coefficient de conversion de champ magnétique-courant pour un cas où un trajet de décharge présente une longueur de référence et est vertical par rapport au sol ;
multiplier le courant déterminé par un coefficient de correction basé sur des valeurs estimées d'une longueur et d'une inclinaison du trajet de décharge du foudroiement ; et
intégrer le courant multiplié par le coefficient de correction en vue de déterminer une charge électrique occasionnée par le foudroiement.

# FIG. 1

SYSTEM 100 FOR ESTIMATING ELECTRIC CHARGE OF LIGHTNING STRIKE

20

10 → Hns, Hew

21 A/D

22 LPF

23 RTC

24 STORAGE DEVICE

25 DISTANCE DETERMINATION DEVICE

26 IONOSPHERE INFORMATION GATHERING DEVICE

27 MAGNETIC FIELD–CURRENT RATIO TABLE

28 CURRENT CALCULATION DEVICE

29 ⊗ CORRECTION COEFFICIENT K

30 ∫ → Q

MAGNETIC FIELD–CURRENT RATIO R

DISTANCE L TO LIGHTNING POINT

Hns, Hew

# FIG. 2

# FIG. 3

| TIME STAMP | Hns | Hew | SYNTHETIC MAGNETIC−FIELD INTENSITY H= $\sqrt{\left( Hns^2 + Hew^2 \right)}$ |
|---|---|---|---|
|  |  |  |  |

# FIG. 4

$$\phi = \tan^{-1}\ (Hns / Hew)$$

# FIG. 5

MAGNETIC FIELD-CURRENT
RATIO TABLE 27

| STATE OF IONOSPHERE | DISTANCE L | MAGNETIC FIELD-CURRENT RATIO R |
|---|---|---|
| STATE 1 OF IONOSPHERE | DISTANCE D1-D2 | R1 |
| | DISTANCE D2-D3 | R2 |
| | . . . . | . . . |
| STATE 2 OF IONOSPHERE | DISTANCE D1-D2 | R3 |
| | . . . . | . . . |
| . . . | . . . . | . . . |

# FIG. 6

DETECT LIGHTNING STRIKE

SPECIFY START AND END OF LIGHTNING STRIKE — S1

SPECIFY DISTANCE L TO LIGHTNING POINT — S2

ACQUIRE INFORMATION OF IONOSPHERE — S3

SPECIFY MAGNETIC FIELD-CURRENT RATIO R — S4

$Q=0$ — S5

READ SYNTHETIC MAGNETIC FIELD H AT START OF LIGHTNING STRIKE — S6

$I=H \cdot R$ — S7

$I=K \cdot I$ — S8

$q=I \cdot \Delta t$ — S9

$Q=Q+q$ — S10

END? — S11

NO

ACQUIRE NEXT SYNTHETIC MAGNETIC FIELD H — S12

YES

Q OUTPUT — S13

END

## FIG. 7

## FIG. 8

# FIG. 9

# FIG. 10

# FIG. 11

# FIG. 12

# FIG. 13

# FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006194643 A

- JP 2012251493 A

**Non-patent literature cited in the description**

- **STEVEN A. ; CUMMER.** Unusually intense continuing current in lightning produces delayed mesospheric breakdown. *GEOPHYSICAL RESEARCH LETTERS,* 01 February 2001, vol. 28, 495-498

- Modeling ELF radio atmospheric propagation and extracting lightning currents from ELF observations. **STEVEN A. ; CUMMER.** RADIO SCIENCE. AMERICAN GEOPHYSICAL UNION, 01 March 2000, vol. 35, 385-394